# EUROPEAN PATENT APPLICATION

(11) **EP 4 579 767 A1**
(43) Date of publication of application: **02.07.2025**
(21) Application number: 23922483.5
(22) Date of filing: 13.12.2023
(51) Int. Cl.: H01L 33/62

(54) **LED LAMP BEAD AND PHOTOGRAPHIC AND VIDEOGRAPHIC LAMP**

(30) Priority: 16.02.2023 CN 202320272997 U; 16.02.2023 CN 202310153367; 23.02.2023 CN 202320372430 U
(71) Applicant: Yingyou Equipment Co., Ltd., Shenzhen, Guangdong 518000 (CN)
(72) Inventor: ZENG, Weiling, Shenzhen, Guangdong 518000 (CN)
(74) Representative: Studio Torta S.p.A.
(86) International application number: PCT/CN2023/138445
(87) International publication number: WO 2024/169367

(57) **Abstract**

An LED lamp bead (100) and a photographic and videographic lamp. The LED lamp bead (100) comprises a substrate (10), a chip (20) and signal pin groups (30), the chip (20) being arranged on the substrate (10); each signal pin group (30) comprises, electrically connected to the chip (20), signal input ends (301, 302, 303) and signal output ends (311, 312, 313); the signal pin groups (30) are arranged on peripheral side edges of the substrate (10), and at least two side edges of the substrate (10) are both provided with the signal pin groups (30).

## Description

### TECHNICAL FIELD

The present application claims the priority of a Chinese patent application No. 202320372430.0, titled "LED Lamp Bead", filed on February 23, 2023, a Chinese patent application No. 202320272997.0, titled "LED Lamp Bead", filed on February 16, 2023, and a Chinese patent application No. 202310153367.6, titled "LED Lamp Bead", filed on February 16, 2023, the entire contents of which are incorporated herein by reference.

### TECHNICAL FIELD

The present application relates to the technical field of display devices, and particularly to a Light Emitting Diode (LED) lamp bead and a photographic and videographic lamp.

### BACKGROUND

Light Emitting Diodes (LEDs) have advantages such as high brightness, energy efficiency, environmental friendliness, fast response speed, vivid colors, and long service life, and are widely used in fields such as lighting and display.

LED lamp lights are mainly used in various live broadcast rooms, studios, etc. In LED lamp lights, multiple LED chips are usually installed on one lamp bead to display different light colors. For existing LED lamp beads, the positions of their pins are not flexible. The signal wires can only enter from one side of the lamp bead and are led out from the opposite side of the lamp bead. In order to achieve different lighting effects, sometimes it is necessary to rotatably install the lamp beads on the lamp panel. However, after rotatably installing the lamp beads, the circuit wiring on the lamp panel is rather messy, and the installation is also inconvenient, which affects the use and assembly of the lamp beads.

### SUMMARY

One objective of the present application is to solve the technical problem that in the existing LED lamp beads, the positions of the pins are inflexible, the signal wires can only enter from one side of the lamp bead and be led out from the opposite side of the lamp bead, and after the lamp beads are rotatably installed, the circuit wiring on the light panel is rather messy, the installation is also inconvenient, which affects the use and assembly of the lamp beads.

To solve the above technical problem, the present application provides a Light Emitting Diode (LED) lamp bead, which includes:
a substrate;
a chip, provided on the substrate;
a signal pin group, comprising a signal input terminal and a signal output terminal electrically connected to the chip;
where the signal pin group is provided on a peripheral side of the substrate, and each of at least two sides of the substrate is provided with the signal pin group.

In one embodiment, each side of the substrate is provided with at least one signal input terminal and at least one signal output terminal.

In one embodiment, the chip is a white light chip and/or a monochromatic chip;
when the chip is the white light chip, the signal pin group includes a positive signal input terminal and a negative signal output terminal electrically connected to the white light chip, and at least one positive signal input terminal and at least one negative signal output terminal are provided on each side of the substrate;
when the chip is the monochromatic chip, the monochromatic chip includes at least one R chip and/or at least one G chip and/or at least one B chip;
the signal pin group includes a first signal input terminal and a first signal output terminal electrically connected to the R chip, a second signal input terminal and a second signal output terminal electrically connected to the G chip, and a third signal input terminal and a third signal output terminal electrically connected to the B chip; and
each side of the substrate is provided with the first signal input terminal, the first signal output terminal, the second signal input terminal, the second signal output terminal, the third signal input terminal and the third signal output terminal.

In one embodiment, the LED lamp bead further includes a signal wire;
the signal wire includes:
a first signal input wire connected to the first signal input terminal and a first signal output wire connected to the first signal output terminal;
a second signal input wire connected to the second signal input terminal and a second signal output wire connected to the second signal output terminal; and
a third signal input wire connected to the third signal input terminal and a third signal output wire connected to the third signal output terminal.

In one embodiment, the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are provided on two adjacent sides of the substrate, respectively.

In one embodiment, the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are provided on two opposite sides of the substrate, respectively.

In one embodiment, the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are all provided on the same side of the substrate.

In one embodiment, the substrate is of a polygonal structure, and each side of the substrate is provided with the positive signal input terminal and the negative signal output terminal.

In one embodiment, the LED lamp bead further includes a signal wire, and the signal wire comprises a positive signal wire connected to the positive signal input terminal and a negative signal wire connected to the negative signal output terminal.

In one embodiment, the positive signal wire and the negative signal wire are provided on two adjacent sides of the substrate.

In one embodiment, the positive signal wire and the negative signal wire are provided on two opposite sides of the substrate.

In one embodiment, the positive signal wire and the negative signal wire are provided on the same side of the substrate.

In one embodiment, the signal input terminals on each side of the substrate are arranged in a set order.

In one embodiment, the signal output terminals on each side of the substrate are arranged in a set order.

In one embodiment, the signal input terminals and the signal output terminals on each side of the substrate are arranged symmetrically relative to a center of the substrate.

The present application provides a photographic and videographic lamp, including a lamp panel and the LED lamp bead as mentioned, a plurality of LED lamp beads are provided in an array on the lamp panel.

It can be seen from the above technical solutions that the beneficial effects of the present application are as follows: In the LED lamp bead and the photographic and videographic lamp of the present application, each of at least two sides of the substrate is provided with signal input terminals and signal output terminals. When the LED lamp bead is rotationally assembled according to the installation environment, appropriate signal input terminals and signal output terminals on the substrate can be selected according to the actual product requirements to conduct the circuit of the chip, avoiding messy circuit wiring, simplifying the assembly of the LED lamp bead, thereby optimizing the circuit wiring and installation layout of the LED lamp bead, and ensuring the use and assembly of the LED lamp bead in environments with different requirements.

### BRIEF DESCRIPTION OF THE DRAWINGS

FIG. 1 is a schematic structural diagram of an embodiment of the LED lamp bead of the present application.
FIG. 2 is another schematic structural diagram of an embodiment of the LED lamp bead of the present application.
FIG. 3 is a schematic structural diagram of the connection situation of the signal wire of an embodiment of the LED lamp bead of the present application.
FIG. 4 is a schematic structural diagram of the connection situation of the signal wire of another embodiment of the LED lamp bead of the present application.
FIG. 5 is a schematic structural diagram of the connection situation of the signal wires of yet another embodiment of the LED lamp bead of the present application.

Reference numbers: 100, an LED lamp bead; 10, a substrate; 11, a first side; 12, a second side; 13, a third side; 14, a fourth side; 20, a chip; 21, a R chip; 22, a G chip; 23, a B chip; 30, a signal pin group; 301, a first signal input terminal; 311, a first signal output terminal; 302, a second signal input terminal; 312, a second signal output terminal; 303, a third signal input terminal; 313, a third signal output terminal; 40, a signal wire; 401, a first signal input wire; 411, a first signal output wire; 402, a second signal input wire; 412, a second signal output wire; 403, a third signal input wire; 413, a third signal output wire.

### DETAILED DESCRIPTION OF THE EMBODIMENTS

Embodiments embodying the features and advantages of the present application will be described in detail in the following description. It is to be understood that the present application is capable of various variations in different embodiments, none of which is outside the scope of the present application, and that the descriptions and drawings therein are intended to be illustrative in nature and are not intended to limit the present application.

In the description of the present application, it is to be understood that in the embodiments shown in the accompanying drawings, indications of orientation or positional relationships (such as up, down, left, right, forward and backward, etc.) are provided solely for the purpose of facilitating and simplifying the description of the present application, rather than indicating or implying that the device or element referred to must have a particular orientation, be constructed and operated in a particular orientation. These descriptions are appropriate when these elements are in the positions shown in the accompanying drawings. If the description of the position of these elements is changed, the indications of these orientations are changed accordingly.

In addition, the terms "first" and "second" are used only for descriptive purposes and are not to be understood as indicating or implying relative importance or implicitly specifying the number of technical features indicated. Thus, a feature defined with "first" and "second" may expressly or implicitly include one or more of the described features. In the description of the present application, "more than one" means two or more, unless otherwise expressly and specifically limited.

The present application provides an LED lamp bead, which includes a substrate, a chip, and a signal pin group. The chip is provided on the substrate. There are a plurality of signal pin groups, and each signal pin group includes a signal input terminal and a signal output terminal that are electrically connected to the chip. The plurality of signal pin groups are provided on the peripheral sides of the substrate, and each of at least two sides of the substrate is provided with at least one signal input terminal and at least one signal output terminal.

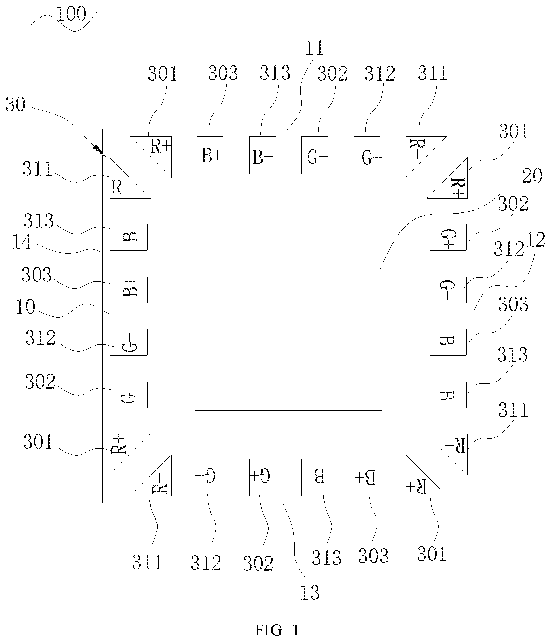

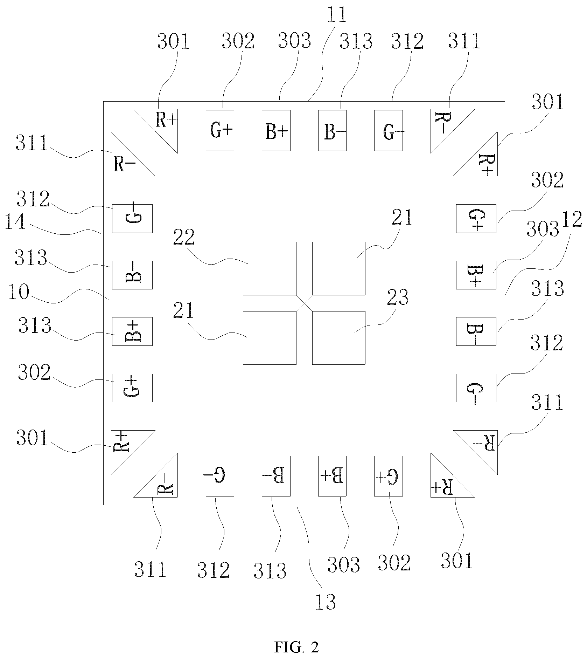

Referring to FIGS. 1 and 2, in the LED lamp bead 100 of an embodiment of the present application, the chip 20 includes at least one R chip 21, at least one G chip 22, and at least one B chip 23. The R chip 21 is a red light LED chip 20, the G chip 22 is a green light LED chip 20, and the B chip 23 is a blue light LED chip 20.

In this embodiment, the substrate 10 is of a quadrilateral structure. The four sides of the substrate 10 are the first side 11, the second side 12, the third side 13, and the fourth side 14 that are sequentially connected. The first side 11 is provided opposite to the third side 13, and the second side 12 is provided opposite to the fourth side 14. In this embodiment, there are two R chips 21, one G chip 22, and one B chip 23 respectively. The two R chips 21, one G chip 22, and one B chip 23 are all provided at the central position of the substrate 10 and are provided in a matrix.

In other examples of this embodiment, the substrate 10 can also be of other polygonal structures, such as a triangle, a pentagon, a hexagon, etc., and its shape can be determined according to the actual product structure, and there is no excessive limitation here. As long as each side of the substrate 10 is provided with a signal input terminal and a signal output terminal.

The signal pin group 30 of this embodiment includes a first signal input terminal 301, a first signal output terminal 311, a second signal input terminal 302, a second signal output terminal 312, a third signal input terminal 303, and a third signal output terminal 313. The signal pin group 30 is provided on the substrate 10 for the electrical conduction of the chip 20.

The first signal input terminal 301 is connected to the positive electrode of the R chip 21, and the first signal output terminal 311 is connected to the negative electrode of the R chip 21. The second signal input terminal 302 is connected to the positive electrode of the G chip 22, and the second signal output terminal 312 is connected to the negative electrode of the G chip 22. The third signal input terminal 303 is connected to the positive electrode of the B chip 23, and the third signal output terminal 313 is connected to the negative electrode of the B chip 23.

In this embodiment, the first side 11 of the substrate 10 is provided with a first signal input terminal 301, a first signal output terminal 311, a second signal input terminal 302, a second signal output terminal 312, a third signal input terminal 303, and a third signal output terminal 313 provided at any intervals. The second side 12 of the substrate 10 is provided with the first signal input terminal 301, the first signal output terminal 311, the second signal input terminal 302, the second signal output terminal 312, the third signal input terminal 303, and the third signal output terminal 313 provided at any intervals. The third side 13 of the substrate 10 is provided with the first signal input terminal 301, the first signal output terminal 311, the second signal input terminal 302, the second signal output terminal 312, the third signal input terminal 303, and the third signal output terminal 313 provided at any intervals. The fourth side 14 of the substrate 10 is provided with the first signal input terminal 301, the first signal output terminal 311, the second signal input terminal 302, the second signal output terminal 312, the third signal input terminal 303, and the third signal output terminal 313 provided at any intervals.

For the LED lamp bead 100 of this embodiment, since each of the four sides of the substrate 10 is provided with signal input terminals and signal output terminals, when the LED lamp bead 100 is assembled during production, the signal input terminals and signal output terminals on any side can be selected for wiring according to the actual assembly situation, which ensures the flexibility of wiring and simplifies the circuit wiring on the lamp, and the installation of the lamp bead is optimized.

In other examples of this embodiment, the monochromatic chip may only include one of the R chip 21, the G chip 22, or the B chip 23. Correspondingly, when the monochromatic chip is the R chip 21, the peripheral sides of the substrate 10 are all provided with the first signal input terminal 301 and the first signal output terminal 311. When the monochromatic chip is the G chip 22, the peripheral sides of the substrate 10 are all provided with the second signal input terminal 302 and the second signal output terminal 312. When the monochromatic chip is the B chip 23, the peripheral sides of the substrate 10 are all provided with the third signal input terminal 303 and the third signal output terminal 313.

In some other examples of this embodiment, the monochromatic chip may also only include the R chip 21 and the G chip 22, or only include the R chip 21 and the B chip 23, or only include the G chip 22 and the B chip 23. Correspondingly, when the monochromatic chip only includes the R chip 21 and the G chip 22, the peripheral sides of the substrate 10 are all provided with the first signal input terminal 301, the first signal output terminal 311, the second signal input terminal 302, and the second signal output terminal 312. When the monochromatic chip only includes the R chip 21 and the B chip 23, the peripheral sides of the substrate 10 are all provided with the first signal input terminal 301, the first signal output terminal 311, the third signal input terminal 303, and the third signal output terminal 313. When the monochromatic chip only includes the G chip 22 and the B chip 23, the peripheral sides of the substrate 10 are all provided with the second signal input terminal 302, the second signal output terminal 312, the third signal input terminal 303, and the third signal output terminal 313.

In addition, in some other embodiments, a white chip and a monochromatic chip can be simultaneously provided on the substrate 10, or only a white chip or only a monochromatic chip can be provided. The monochromatic chip includes one or more of the R chip 21, the G chip 22, or the B chip 23.

Furthermore, the LED lamp bead 100 of this embodiment also includes a signal wire 40. The signal wire 40 includes a first signal input wire 401 connected to the first signal input terminal 301 and a first signal output wire 411 connected to the first signal output terminal 311, a second input signal wire 402 connected to the second signal input terminal 302 and a second output signal wire 40 connected to the second signal output terminal 312, and a third input signal wire 40 connected to the third signal input terminal 303 and a third output signal wire 40 connected to the third signal output terminal 313.

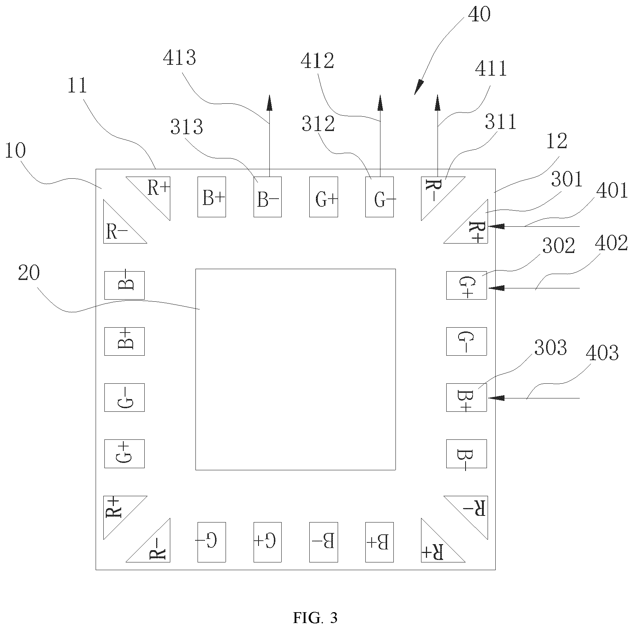

As shown in FIG. 3, in this embodiment, according to the actual installation situation of the LED lamp bead 100, the signal wire 40 can be selected to be connected to the signal pin groups 30 on two adjacent sides of the substrate 10.

Specifically, the first signal output wire 411, the second signal output wire 412, and the third signal output wire 413 are provided on the first side 11 of the substrate 10, that is, the first signal output wire 411 is connected to the first signal output terminal 311 on the first side 11, the second signal output wire 412 is connected to the second signal output terminal 312 on the first side 11, and the third signal output wire 413 is connected to the third signal output terminal 313 on the first side 11.

The first signal input wire 401, the second signal input wire 402, and the third signal input wire 403 are provided on the second side 12 of the substrate 10, that is, the first signal input wire 401 is connected to the first signal input terminal 301 on the second side 12, the second signal input wire 402 is connected to the second signal input terminal 302 on the second side 12, and the third signal input wire 403 is connected to the third signal input terminal 303 on the second side 12.

In other examples of this embodiment, the first signal input wire 401 can also be connected to the first signal input terminal 301 on the first side 11, the second signal input wire 402 can be connected to the second signal input terminal 302 on the first side 11, and the third signal input wire 403 can be connected to the third signal input terminal 303 on the first side 11. The first signal output wire 411 is connected to the first signal output terminal 311 on the first side 11, the second signal output wire 412 is connected to the second signal output terminal 312 on the first side 11, and the third signal output wire 413 is connected to the third signal output terminal 313 on the second side 12.

Alternatively, the first signal output wire 411 can be connected to the first signal output terminal 311 on the second side 12, the second signal output wire 412 can be connected to the second signal output terminal 312 on the second side 12, and the third signal output wire 413 can be connected to the third signal output terminal 313 on the second side 12. The first signal input wire 401 is connected to the first signal input terminal 301 on the third side 13, the second signal input wire 402 is connected to the second signal input terminal 302 on the third side 13, and the third signal input wire 403 is connected to the third signal input terminal 303 on the third side 13.

Alternatively, the first signal input wire 401 is connected to the first signal input terminal 301 on the second side 12, the second signal input wire 402 is connected to the second signal input terminal 302 on the second side 12, and the third signal input wire 403 is connected to the third signal input terminal 303 on the second side 12. The first signal output wire 411 is connected to the first signal output terminal 311 on the third side 13, the second signal output wire 412 is connected to the second signal output terminal 312 on the third side 13, and the third signal output wire 413 is connected to the third signal output terminal 313 on the third side 13.

Alternatively, the first signal output wire 411 can be connected to the first signal output terminal 311 on the third side 13, the second signal output wire 412 can be connected to the second signal output terminal 312 on the third side 13, and the third signal output wire 413 can be connected to the third signal output terminal 313 on the third side 13. The first signal input wire 401 is connected to the first signal input terminal 301 on the fourth side 14, the second signal input wire 402 is connected to the second signal input terminal 302 on the fourth side 14, and the third signal input wire 403 is connected to the third signal input terminal 303 on the fourth side 14.

Alternatively, the first signal input wire 401 is connected to the first signal input terminal 301 on the third side 13, the second signal input wire 402 is connected to the second signal input terminal 302 on the third side 13, and the third signal input wire 403 is connected to the third signal input terminal 303 on the third side 13. The first signal output wire 411 is connected to the first signal output terminal 311 on the fourth side 14, the second signal output wire 412 is connected to the second signal output terminal 312 on the fourth side 14, and the third signal output wire 413 is connected to the third signal output terminal 313 on the fourth side 14.

Alternatively, the first signal output wire 411 can be connected to the first signal output terminal 311 on the fourth side 14, the second signal output wire 412 can be connected to the second signal output terminal 312 on the fourth side 14, and the third signal output wire 413 can be connected to the third signal output terminal 313 on the fourth side 14. The first signal input wire 401 is connected to the first signal input terminal 301 on the first side 11, the second signal input wire 402 is connected to the second signal input terminal 302 on the first side 11, and the third signal input wire 403 is connected to the third signal input terminal 303 on the first side 11.

Alternatively, the first signal input wire 401 is connected to the first signal input terminal 301 on the fourth side 14, the second signal input wire 402 is connected to the second signal input terminal 302 on the fourth side 14, and the third signal input wire 403 is connected to the third signal input terminal 303 on the fourth side 14. The first signal output wire 411 is connected to the first signal output terminal 311 on the first side 11, the second signal output wire 412 is connected to the second signal output terminal 312 on the first side 11, and the third signal output wire 413 is connected to the third signal output terminal 313 on the first side 11.

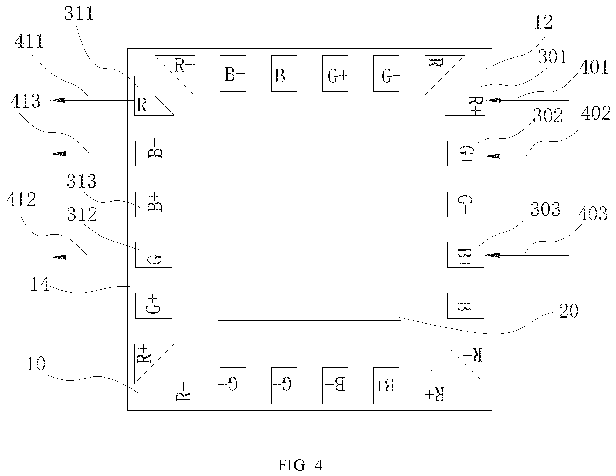

Referring to FIG. 4, in another embodiment of the present application, according to the actual installation situation of the LED lamp bead 100, the signal wire 40 can be selected to be connected to the signal pin groups 30 on two opposite sides of the substrate 10.

Specifically, the first signal output wire 411, the second signal output wire 412, and the third signal output wire 413 are provided on the fourth side 14 of the substrate 10, that is, the first signal output wire 411 is connected to the first signal output terminal 311 on the fourth side 14, the second signal output wire 412 is connected to the second signal output terminal 312 on the fourth side 14, and the third signal output wire 413 is connected to the third signal output terminal 313 on the fourth side 14.

The first signal input wire 401, the second signal input wire 402, and the third signal input wire 403 are provided on the second side 12 of the substrate 10, that is, the first signal input wire 401 is connected to the first signal input terminal 301 on the second side 12, the second signal input wire 402 is connected to the second signal input terminal 302 on the second side 12, and the third signal input wire 403 is connected to the third signal input terminal 303 on the second side 12.

In other examples of this embodiment, the first signal input wire 401 can also be connected to the first signal input terminal 301 on the fourth side 14, the second signal input wire 402 can be connected to the second signal input terminal 302 on the fourth side 14, and the third signal input wire 403 can be connected to the third signal input terminal 303 on the fourth side 14. The first signal output wire 411 is connected to the first signal output terminal 311 on the second side 12, the second signal output wire 412 is connected to the second signal output terminal 312 on the second side 12, and the third signal output wire 413 is connected to the third signal output terminal 313 on the second side 12.

Alternatively, the first signal output wire 411 is connected to the first signal output terminal 311 on the first side 11, the second signal output wire 412 is connected to the second signal output terminal 312 on the first side 11, and the third signal output wire 413 is connected to the third signal output terminal 313 on the first side 11. The first signal input wire 401 is connected to the first signal input terminal 301 on the third side 13, the second signal input wire 402 is connected to the second signal input terminal 302 on the third side 13, and the third signal input wire 403 is connected to the third signal input terminal 303 on the third side 13.

Alternatively, the first signal input wire 401 is connected to the first signal input terminal 301 on the first side 11, the second signal input wire 402 is connected to the second signal input terminal 302 on the first side 11, and the third signal input wire 403 is connected to the third signal input terminal 303 on the first side 11. The first signal output wire 411 is connected to the first signal output terminal 311 on the third side 13, the second signal output wire 412 is connected to the second signal output terminal 312 on the third side 13, and the third signal output wire 413 is connected to the third signal output terminal 313 on the third side 13.

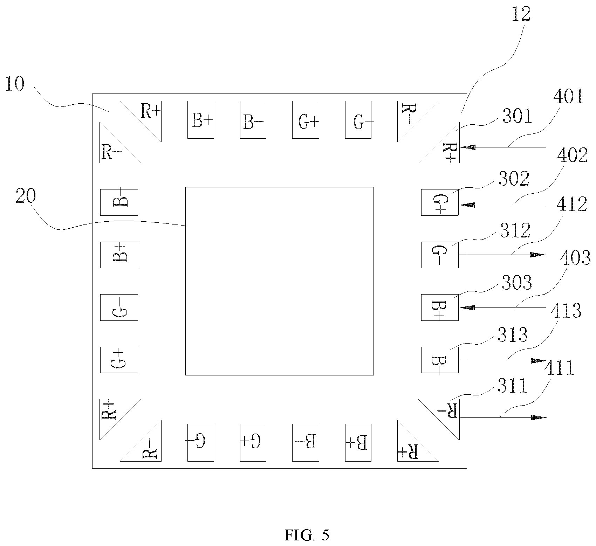

Referring to FIG. 5, in yet another embodiment of the present application, according to the actual installation situation of the LED lamp bead 100, the signal wire 40 can be selected to be connected to the signal pin groups 30 on the same side of the substrate 10.

Specifically, the first signal output wire 411, the second signal output wire 412, and the third signal output wire 413 are provided on the second side 12 of the substrate 10, that is, the first signal output wire 411 is connected to the first signal output terminal 311 on the second side 12, the second signal output wire 412 is connected to the second signal output terminal 312 on the second side 12, and the third signal output wire 413 is connected to the third signal output terminal 313 on the second side 12.

The first signal input wire 401, the second signal input wire 402, and the third signal input wire 403 are provided on the second side 12 of the substrate 10, that is, the first signal input wire 401 is connected to the first signal input terminal 301 on the second side 12, the second signal input wire 402 is connected to the second signal input terminal 302 on the second side 12, and the third signal input wire 403 is connected to the third signal input terminal 303 on the second side 12.

In other examples of this embodiment, the first signal input wire 401 can also be connected to the first signal input terminal 301 on the first side 11, the second signal input wire 402 can be connected to the second signal input terminal 302 on the first side 11, and the third signal input wire 403 can be connected to the third signal input terminal 303 on the first side 11. The first signal output wire 411 is connected to the first signal output terminal 311 on the first side 11, the second signal output wire 412 is connected to the second signal output terminal 312 on the first side 11, and the third signal output wire 413 is connected to the third signal output terminal 313 on the first side 11.

Alternatively, the first signal input wire 401 can be connected to the first signal input terminal 301 on the third side 13, the second signal input wire 402 can be connected to the second signal input terminal 302 on the third side 13, and the third signal input wire 403 can be connected to the third signal input terminal 303 on the third side 13. The first signal output wire 411 is connected to the first signal output terminal 311 on the third side 13, the second signal output wire 412 is connected to the second signal output terminal 312 on the third side 13, and the third signal output wire 413 is connected to the third signal output terminal 313 on the third side 13.

Alternatively, the first signal input wire 401 can be connected to the first signal input terminal 301 on the fourth side 14, the second signal input wire 402 can be connected to the second signal input terminal 302 on the fourth side 14, and the third signal input wire 403 can be connected to the third signal input terminal 303 on the fourth side 14. The first signal output wire 411 is connected to the first signal output terminal 311 on the fourth side 14, the second signal output wire 412 is connected to the second signal output terminal 312 on the fourth side 14, and the third signal output wire 413 is connected to the third signal output terminal 313 on the fourth side 14.

Since signal input terminals and signal output terminals are provided on the peripheral sides of the substrate 10, when installing the LED lamp bead 100, the LED lamp bead 100 can be arbitrarily rotated and assembled according to the installation environment, and the signal input terminals and signal output terminals on the substrate 10 can be arbitrarily selected according to the actual product requirements to conduct the circuit of the chip 20, thereby optimizing the circuit wiring and installation layout of the LED lamp bead 100 and ensuring the use and assembly of the LED lamp bead 100 in environments with different requirements.

In addition, in this embodiment, as shown in FIG. 4, the signal input terminals and signal output terminals on each side of the substrate 10 are all provided in a set order, for example, the first signal input terminal 301, the second signal input terminal 302, the second signal output terminal 312, the third signal input terminal 303, the first signal output terminal 311, and the third signal output terminal 313 can be arranged sequentially. And the signal input terminals and signal output terminals on each side of the substrate are all arranged symmetrically relative to a center of the substrate.

Such arrangement makes it possible that no matter whether the chip 20 rotates 90° or 180° clockwise or counterclockwise, the signal input terminals and signal output terminals at the top of the substrate 10 are all provided in the set order, which is convenient for users to wire, avoiding wrong wiring, and ensuring the accuracy and speed of wiring.

In other embodiments of the present application, the chip 20 can also be a white light chip 20 and/or a monochromatic chip 20. The monochromatic chip 20 can be one of the R chip 21, the G chip 22, or the B chip 23.

Taking the white light chip 20 as an example, the signal pin group 30 of the LED lamp bead 100 includes a positive signal input terminal and a negative signal output terminal that are electrically connected to the white light chip 20. The substrate 10 of this embodiment is of a quadrilateral structure, and each of four sides of the substrate 10 are all provided with the positive signal input terminal and the negative signal output terminal.

In this embodiment, the LED lamp bead 100 also includes a signal wire 40, and the signal wire 40 includes a positive signal wire connected to the positive signal input terminal and a negative signal wire connected to the negative signal output terminal. When assembling the LED lamp bead 100, the positive signal input terminal and the negative signal output terminal on any side of the substrate 10 can be selected for circuit conduction according to actual needs.

In other examples of this embodiment, when the chip 20 includes a white chip and a monochromatic chip, taking the monochromatic chip as the R chip 21 as an example, the peripheral sides of the substrate 10 are all provided with the positive signal input terminal, the negative signal output terminal, the first signal input terminal 301, and the first signal output terminal 311.

Specifically, the positive signal wire and the negative signal wire can be respectively provided on two opposite sides of the substrate 10, or the positive signal wire and the negative signal wire can be respectively provided on two adjacent sides of the substrate 10, or the positive signal wire and the negative signal wire can be provided on the same side of the substrate 10.

In addition, an embodiment of the present application also provides a photographic and videographic lamp, which includes the above-mentioned LED lamp beads 100 and a light panel. A plurality of LED lamp beads 100 are provided in an array on the light panel. Such arrangement enables the adjacent LED lamp beads 100 in the same row, after being rotated, to still be uniformly wired on the same side of this row, thereby facilitating the wiring operation on the light panel and optimizing the layout of the wires.

For the LED lamp bead and the photographic and videographic lamp of the present application, each of at least two sides of the substrate is provided with signal input terminals and signal output terminals. When the LED lamp bead is rotationally assembled according to the installation environment, appropriate signal input terminals and signal output terminals on the substrate can be selected according to the actual product requirements to conduct the circuit of the chip, avoiding messy circuit wiring, simplifying the assembly of the LED lamp bead, thereby optimizing the circuit wiring and installation layout of the LED lamp bead, and ensuring the use and assembly of the LED lamp bead in environments with different requirements.

While the present application is described with reference to several exemplary embodiments, it should be understood that the terms used are illustrative and exemplary, not limiting. Since the present application can be practiced in a variety of forms without departing from the spirit or substance of the present application, it should be understood that the foregoing embodiments are not limited to any of the foregoing details but should be construed broadly within the spirit and scope of the accompanying claims, and therefore all variations and adaptations falling within the scope of the claims, or their equivalents, should be covered by the accompanying claims.

## Claims

1. A Light Emitting Diode (LED) lamp bead, **characterized by** comprising:
a substrate;
a chip, provided on the substrate;
a signal pin group, comprising a signal input terminal and a signal output terminal electrically connected to the chip;
wherein the signal pin group is provided on a peripheral side of the substrate, and each of at least two sides of the substrate is provided with the signal pin group.

2. The LED lamp bead according to claim 1, wherein each side of the substrate is provided with at least one signal input terminal and at least one signal output terminal.

3. The LED lamp bead according to claim 1, wherein the chip is a white light chip and/or a monochromatic chip;
when the chip is the white light chip, the signal pin group comprises a positive signal input terminal and a negative signal output terminal electrically connected to the white light chip, and at least one positive signal input terminal and at least one negative signal output terminal are provided on each side of the substrate;
when the chip is the monochromatic chip, the monochromatic chip comprises at least one R chip and/or at least one G chip and/or at least one B chip;
the signal pin group comprises a first signal input terminal and a first signal output terminal electrically connected to the R chip, a second signal input terminal and a second signal output terminal electrically connected to the G chip, and a third signal input terminal and a third signal output terminal electrically connected to the B chip; and
each side of the substrate is provided with the first signal input terminal, the first signal output terminal, the second signal input terminal, the second signal output terminal, the third signal input terminal and the third signal output terminal.

4. The LED lamp bead according to claim 3, wherein the LED lamp bead further comprises a signal wire;
the signal wire comprises:
a first signal input wire connected to the first signal input terminal and a first signal output wire connected to the first signal output terminal;
a second signal input wire connected to the second signal input terminal and a second signal output wire connected to the second signal output terminal; and
a third signal input wire connected to the third signal input terminal and a third signal output wire connected to the third signal output terminal.

5. The LED lamp bead according to claim 4, wherein the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are provided on two adjacent sides of the substrate, respectively.

6. The LED lamp bead according to claim 4, wherein the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are provided on two opposite sides of the substrate, respectively.

7. The LED lamp bead according to claim 4, wherein the substrate is of a polygonal structure, and each side of the substrate is provided with the first signal input terminal, the first signal output terminal, the second signal input terminal, the second signal output terminal, the third signal input terminal and the third signal output terminal; and
the first signal input wire, the second signal input wire and the third signal input wire, and the first signal output wire, the second signal output wire and the third signal output wire are all provided on the same side of the substrate.

8. The LED lamp bead according to claim 3, wherein the substrate is of a polygonal structure, and each side of the substrate is provided with the positive signal input terminal and the negative signal output terminal.

9. The LED lamp bead according to claim 8, wherein the LED lamp bead further comprises a signal wire, and the signal wire comprises a positive signal wire connected to the positive signal input terminal and a negative signal wire connected to the negative signal output terminal.

10. The LED lamp bead according to claim 9, wherein the positive signal wire and the negative signal wire are provided on two adjacent sides of the substrate.

11. The LED lamp bead according to claim 9, wherein the positive signal wire and the negative signal wire are provided on two opposite sides of the substrate.

12. The LED lamp bead according to claim 9, wherein the positive signal wire and the negative signal wire are provided on the same side of the substrate.

13. The LED lamp bead according to claim 2, wherein the signal input terminals on each side of the substrate are arranged in a set order.

14. The LED lamp bead according to claim 13, wherein the signal output terminals on each side of the substrate are arranged in a set order.

15. The LED lamp bead according to claim 14, wherein the signal input terminals and the signal output terminals on each side of the substrate are arranged symmetrically relative to a center of the substrate.

16. A photographic and videographic lamp, **characterized by** comprising a lamp panel and the LED lamp bead according to any one of claims 1-15, wherein a plurality of LED lamp beads are provided in an array on the lamp panel.
